# EUROPEAN PATENT APPLICATION

(11) **EP 4 726 998 A1**
(43) Date of publication of application: **15.04.2026**
(21) Application number: 24823312.4
(22) Date of filing: 07.06.2024
(51) Int. Cl.: H02N 2/04, G02B 7/04, G02B 7/08, H10N 30/20, H10N 30/853

(54) **VIBRATION ACTUATOR, ELECTRONIC DEVICE, OPTICAL DEVICE, AND MANUFACTURING METHOD FOR VIBRATION ACTUATOR**

(30) Priority: 12.06.2023 JP 2023096027
(71) Applicant: Canon Kabushiki Kaisha, Tokyo, 146-8501 (JP)
(72) Inventor: UEBAYASHI Akira, Tokyo 146-8501 (JP); WATANABE Takayuki, Tokyo 146-8501 (JP)
(74) Representative: Canon Europe Limited
(86) International application number: PCT/JP2024/020803
(87) International publication number: WO 2024/257696

(57) **Abstract**

A vibration-type actuator of the present invention includes a vibrator including an electromechanical energy conversion element and an elastic body, the elastic body having a plate portion and protruding portions that protrude in the same direction out of a plane of the plate portion, a contact body that is in contact with the protruding portions of the vibrator and that moves relative to the vibrator, a foamed member that is in contact with the vibrator, and an urging member that urges the vibrator toward the contact body via the foamed member. The foamed member includes siloxane bonds, Si-OSi, made of silicon and oxygen, and a ratio N_{Q}/N_{D} of the number N_{Q} of Q units to the number N_{D} of D units is greater than or equal to 0.09 in silicon contained in the foamed member.

## Description

### Technical Field

The present invention relates to a vibration-type actuator, an electronic device, an optical apparatus, and a manufacturing method for a vibration-type actuator.

### Background Art

A vibration-type actuator includes a vibrator made up of an elastic body and an electromechanical energy conversion element, such as a piezoelectric element, and a contact body that is in contact with the vibrator under pressure. Vibration-type actuators are used as vibration wave motors that use the friction generated by the driving force of vibrations excited in the vibrator to relatively move the contact body.

The outline of the structure and drive principle of a vibration wave motor that is a type of vibration-type actuator. The vibration wave motor includes a vibrator and a contact body that is in contact with the vibrator under pressure by an urging member. At this time, in order for the urging member to uniformly apply pressure to the vibrator, the urging member is desirably in contact with the vibrator with the increased rigidity. However, when the high-rigidity member contacts with the vibrator, the vibration of the vibrator is hindered, which leads to the deterioration of the drive characteristics of the motor. Therefore, there is known a structure in which a member that does not hinder vibrations is disposed between the urging member and the vibrator as a vibration attenuation member.

PTL 1 describes that sponge, foamed polystyrene, and felt are listed as a support member for a vibrator and, among them, wool felt is particularly excellent. A support member for a vibrator in PTL 2 is a member for not hindering vibrations and is considered to have a function equivalent to the vibration attenuation member.

PTL 2 also describes a vibration-type actuator that provides stable and sufficient output power over a long period by selecting the average equivalent circle diameter of the cells of a foamed member in the configuration in which the foamed member is disposed between the vibrator and the urging member.

### Citation List

### Patent Literature

PTL 1: Japanese Patent Laid-Open No. 3-289371
PTL 2: Japanese Patent Laid-Open No. 2022-083146

### Summary of Invention

### Technical Problem

Here, there have been cases where the drive characteristics of the vibration-type actuator using the foamed member decrease compared to the drive characteristics of the vibration-type actuator using felt.

The present invention has been made to address the above-described inconveniences and provides a vibration-type actuator that has stable drive characteristics over a long period and improved drive characteristics. The present invention also provides an electronic device and an optical apparatus using a vibration-type actuator that has stable drive characteristics over a long period and improved drive characteristics. The present invention also provides a manufacturing method for a vibration-type actuator that has stable drive characteristics over a long period and improved drive characteristics.

### Solution to Problem

A vibration-type actuator of the present invention includes a vibrator including an electromechanical energy conversion element and an elastic body, the elastic body having a plate portion and protruding portions that protrude in the same direction out of a plane of the plate portion, a contact body that is in contact with the protruding portions of the vibrator and that moves relative to the vibrator, a foamed member that is in contact with the vibrator, and an urging member that urges the vibrator toward the contact body via the foamed member. The foamed member includes siloxane bonds, Si-O-Si, made of silicon and oxygen, and a ratio N_{Q}/N_{D} of the number N_{Q} of Q units to the number N_{D} of D units is greater than or equal to 0.09 in silicon contained in the foamed member.

### Advantageous Effects of Invention

According to the present invention, it is possible to provide a vibration-type actuator that has stable drive characteristics over a long period and improved drive characteristics. According to the present invention, it is possible to provide an electronic device and an optical apparatus using a vibration-type actuator that has stable drive characteristics over a long period and improved drive characteristics. The present invention can also provide a manufacturing method for a vibration-type actuator that has stable drive characteristics over a long period and improved drive characteristics.

### Brief Description of Drawings

[Fig. 1A] Fig. 1A is a diagram illustrating the schematic structure of a vibration-type actuator of the present invention using an annular piezoelectric material or a rectangular piezoelectric material.
[Fig. 1B] Fig. 1B is a diagram illustrating the schematic structure of the vibration-type actuator of the present invention using an annular piezoelectric material or a rectangular piezoelectric material.
[Fig. 1C] Fig. 1C is a diagram illustrating the schematic structure of the vibration-type actuator of the present invention using an annular piezoelectric material or a rectangular piezoelectric material.
[Fig. 1D] Fig. 1D is a diagram illustrating the schematic structure of a vibration-type actuator of the present invention using an annular piezoelectric material or a rectangular piezoelectric material.
[Fig. 1E] Fig. 1E is a diagram illustrating the schematic structure of the vibration-type actuator of the present invention using an annular piezoelectric material or a rectangular piezoelectric material.
[Fig. 1F] Fig. 1F is a diagram illustrating the schematic structure of the vibration-type actuator of the present invention using an annular piezoelectric material or a rectangular piezoelectric material.
[Fig. 2A] Fig. 2A is a diagram illustrating two vibration modes generated by a vibrator of the present invention including a rectangular piezoelectric material.
[Fig. 2B] Fig. 2B is a diagram illustrating two vibration modes generated by the vibrator of the present invention including a rectangular piezoelectric material.
[Fig. 3] Fig. 3 is a schematic cross-sectional view of a foamed member in the present invention.
[Fig. 4A] Fig. 4A is a schematic view of the foamed member in the present invention when viewed from the side.
[Fig. 4B] Fig. 4B is a schematic view of a foamed member in the present invention when viewed from the side.
[Fig. 5A] Fig. 5A is a diagram illustrating a constitutional unit that makes up the backbone structure of a molecule containing a siloxane bond.
[Fig. 5B] Fig. 5B is a diagram illustrating a constitutional unit that makes up the backbone structure of a molecule containing a siloxane bond.
[Fig. 5C] Fig. 5C is a diagram illustrating a constitutional unit that makes up the backbone structure of a molecule containing a siloxane bond.
[Fig. 5D] Fig. 5D is a diagram illustrating a constitutional unit that makes up the backbone structure of a molecule containing a siloxane bond.
[Fig. 6A] Fig. 6A is a ²⁹Si-DD-MAS NMR spectrum obtained through solid-state NMR of a foamed member in the present invention.
[Fig. 6B] Fig. 6B is a ²⁹Si-DD-MAS NMR spectrum obtained through solid-state NMR of a foamed member in the present invention.
[Fig. 7A] Fig. 7A is a diagram showing the molecular structure assigned to each peak of Figs. 6A and 6B.
[Fig. 7B] Fig. 7B is a diagram showing the molecular structure assigned to each peak of Figs. 6A and 6B.
[Fig. 7C] Fig. 7C is a diagram showing the molecular structure assigned to each peak of Figs. 6A and 6B.
[Fig. 7D] Fig. 7D is a diagram showing the molecular structure assigned to each peak of Figs. 6A and 6B.
[Fig. 7E] Fig. 7E is a diagram showing the molecular structure assigned to each peak of Figs. 6A and 6B.
[Fig. 7F] Fig. 7F is a diagram showing the molecular structure assigned to each peak of Figs. 6A and 6B.
[Fig. 7G] Fig. 7G is a diagram showing the molecular structure assigned to each peak of Figs. 6A and 6B.
[Fig. 7H] Fig. 7H is a diagram showing the molecular structure assigned to each peak of Figs. 6A and 6B.
[Fig. 8] Fig. 8 is a view illustrating the schematic structure of an optical apparatus of the present invention.
[Fig. 9] Fig. 9 is a graph showing the drive characteristics of a vibration-type actuator according to an embodiment of the present invention.

### Description of Embodiments

Hereinafter, an embodiment of the present invention will be described.

The present inventors have found that a vibration-type actuator using a foamed member has lower drive characteristics than a vibration-type actuator using felt. As a result of further investigation, the present inventors have found that, when the chemical structure of the foamed member is optimized, a vibration-type actuator that has stable drive characteristics over a long time period and improved drive characteristics can be obtained.

A vibration-type actuator of the present invention includes a vibrator, a contact body, a foamed member, and an urging member. In the vibration-type actuator of the present invention, the foamed member contains siloxane bonds (Si-O-Si), and the ratio N_{Q}/N_{D} of the number N_{Q} of Q units to the number N_{D} of D units is 0.09 or greater. Because the foamed member includes a large amount of Q units, the effect that the structure of siloxane stabilizes is obtained, so a vibration-type actuator of which the drive characteristics are less likely to decrease even after a long-term use can be obtained.

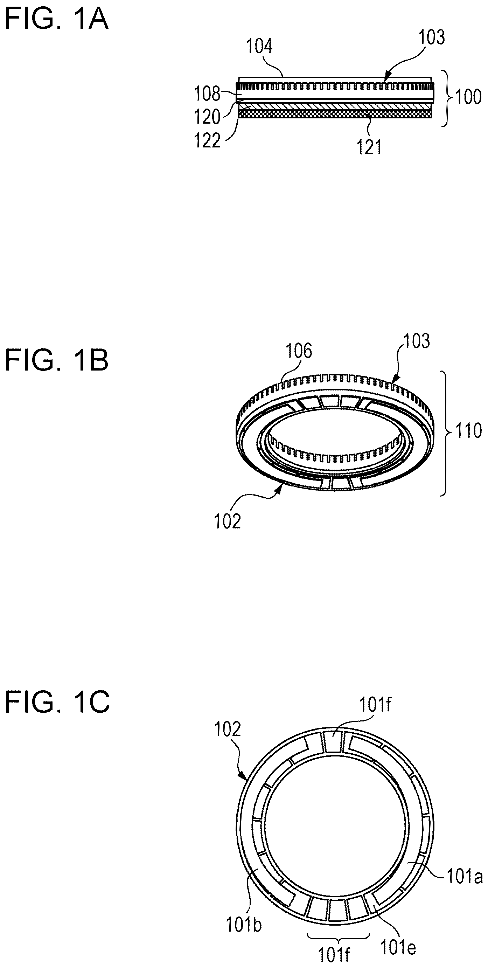

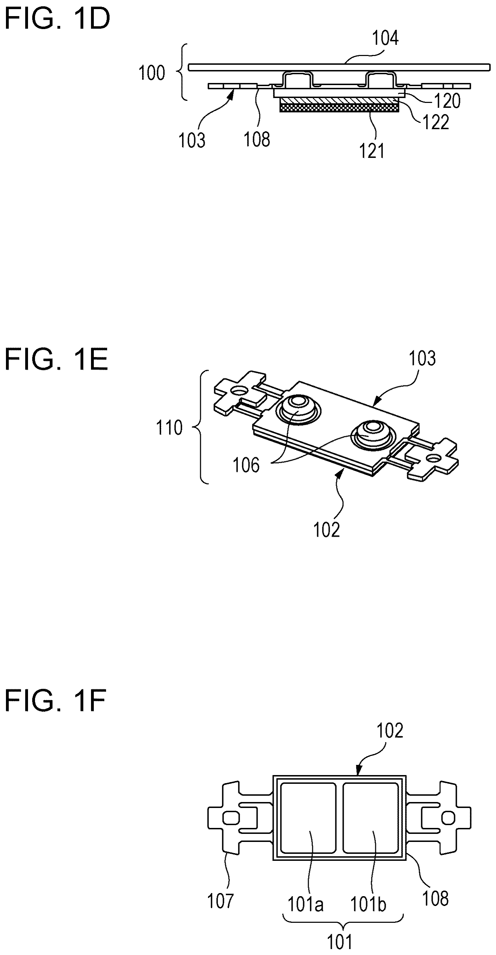

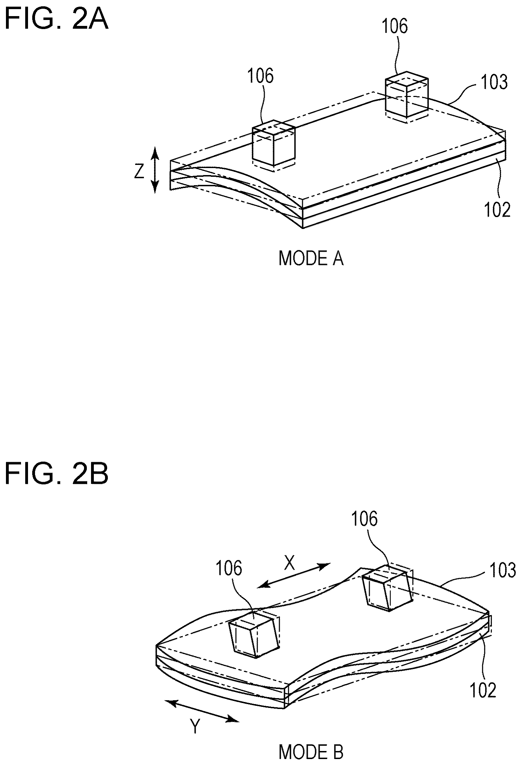

Figs. 1A to 1F, 2A, and 2B illustrate the schematic structures of the vibration-type actuators of the present invention. Figs. 1A and 1D are schematic side views of the vibration-type actuator. Figs. 1B and 1E are perspective views. Figs. 1C and 1F are rear views. Fig. 2A is a view illustrating mode A of a vibration mode, and Fig. 2B is a view illustrating mode B.

In the vibration-type actuators illustrated in Figs. 1A to 1F, 2A, and 2B, a vibrator with an annular plate portion and a vibrator with a rectangular plate portion are used, respectively. The vibration-type actuator 100 of the present invention includes an electromechanical energy conversion element 120 made up of electrodes 101 and a piezoelectric material 102. The vibration-type actuator 100 further includes an elastic body 103 that has a plate portion 108 and protruding portions 106 that protrude in the same direction out of the plane of the plate portion. A vibrator 110 in which these are disposed in order is formed.

The vibration-type actuator 100 further includes a contact body 104 that is in contact with the protruding portions 106. In addition, the vibration-type actuator 100 is configured to include an urging member 121 for bringing (urging) the vibrator 110 into contact with the contact body 104 under pressure, and a foamed member 122 between the vibrator 110 and the urging member 121.

When the vibrator 110 is driven, the vibrator 110 and the contact body 104 move relative to each other. It is sufficient that the contact body 104 be any member that is movable relative to the vibrator 110. The contact body 104 is not limited to the one that is in direct contact with the vibrator 110. The contact body 104 may also be the one that is in indirect contact with the vibrator 110 via another member. The surface of the electromechanical energy conversion element 120 is urged by the urging member 121 toward the contact body 104 via the foamed member 122.

### (Piezoelectric Material)

The shape of the piezoelectric material 102 is not limited; however, when the shape of the plate portion is annular, the piezoelectric material is also preferably annular, and, when the shape of the plate portion is rectangular, the piezoelectric material is also preferably rectangular.

The form of the piezoelectric material 102 is not limited. The form may be, for example, a piezoelectric material without crystal orientation (sintered body), crystal-oriented ceramics, a single crystal piezoelectric material, or the like. The shape that the piezoelectric material can take is not limited. For example, a layered piezoelectric material may be adopted or a single-sheet piezoelectric material may be adopted to form a laminated body of electrodes and a piezoelectric material. From the viewpoint of cost for piezoelectric materials, a single-sheet plate is superior. To drive the vibration-type actuator, polarization is applied to the piezoelectric material. When an alternating-current electric field frequency applied to the polarized piezoelectric material approaches the resonance frequency of the piezoelectric material, the piezoelectric material vibrates significantly due to the resonance phenomenon.

The content of lead in the piezoelectric material used for the electromechanical energy conversion element is preferably less than or equal to 1000ppm from the viewpoint of environmental load.

### (Electrode)

When an annular piezoelectric material is used, the electrodes 101 divided in the circumferential direction are provided on the piezoelectric material, and an annular piezoelectric element is formed. The electrodes 101 include drive phase electrodes 101e and non-drive phase electrodes 101f. The circumferential length of the drive phase electrode is half of the wavelength λ of the vibration wave that occurs in the circumferential direction of the annular piezoelectric element when an alternating voltage is applied to the drive phase electrode. The circumferential length of the non-drive phase electrode (ground electrode, monitor electrode) will be a quarter of the wavelength λ. The number of drive phase electrodes and non-drive phase electrodes changes according to the number of progressive waves that excite the annular piezoelectric material. The piezoelectric material corresponding to each drive phase electrode is subjected to polarization with voltages of different polarities than the adjacent regions.

The drive phase electrodes are separated by odd-numbered non-drive phase electrodes. After the polarization, the first electrode 101a and the second electrode 101b are provided to respectively short-circuit two drive phase electrode groups partitioned by the non-drive phase electrodes. The first electrode 101a and the second electrode 101b are used to drive a vibration-type actuator that adopts an annular piezoelectric material.

When a rectangular piezoelectric material is used, the rectangular electrodes 101 are provided. The electrodes 101 include a first electrode 101a and a second electrode 101b. The first electrode 101a and the second electrode 101b are used for the polarization of the rectangular piezoelectric material and for driving a vibration-type actuator using the rectangular piezoelectric material.

The electrodes are made up of a metal film with a thickness of about 0.3 µm to about 10 µm. The material is not limited; however, generally, silver, gold, or platinum electrodes are used. A manufacturing method for electrodes is not limited, and electrodes can be formed by screen printing, sputtering, vapor deposition, or the like. To produce an electromechanical energy conversion element with a lead content of less than or equal to 1000ppm, pastes or targets with a lead content of less than 1000ppm need to be used in the formation of the electrodes as well.

### (Elastic Body)

The elastic body 103 is preferably made of metal from the viewpoint of its properties and machinability as an elastic body. Examples of metals usable for the elastic body 103 include aluminum, brass, and stainless steel. Among stainless steels, martensitic stainless steel is preferable, and SUS420J2 is the most preferable. The elastic body has protruding portions 106 that are in contact with the contact body. To further improve the wear resistance of the protruding portions, the elastic body is subjected to quenching, plating, or nitriding.

The plate portion of the elastic body is preferably rectangular. By providing the rectangular plate portion of the elastic body, a manufacturing and machining of the electromechanical energy conversion element become easier, so a compact electromechanical energy conversion element can be manufactured. It is also possible to manufacture a compact vibration-type actuator.

### (Foamed Member)

As shown in Fig. 1A, the foamed member 122 is provided on the surface of the electromechanical energy conversion element 120, opposite from the surface where the elastic body 103 is disposed. The foamed member 122 needs to cause the vibrator 110 to uniformly apply pressure to the contact body 104, while having a function as a vibration attenuation member. The function serving as a vibration attenuation member damps vibrations from adjacent members by absorption or the like, and, when the drive characteristics do not decrease, the foamed member 122 may be provided separately.

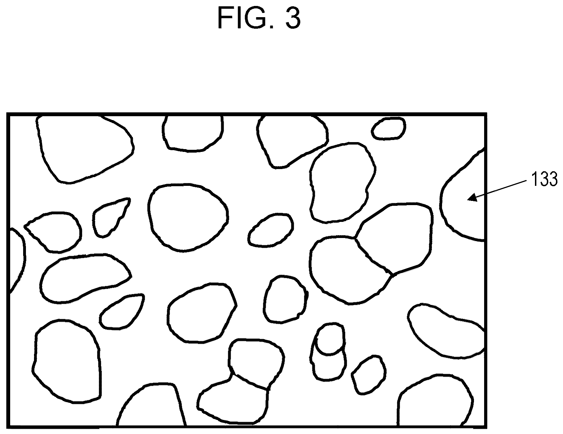

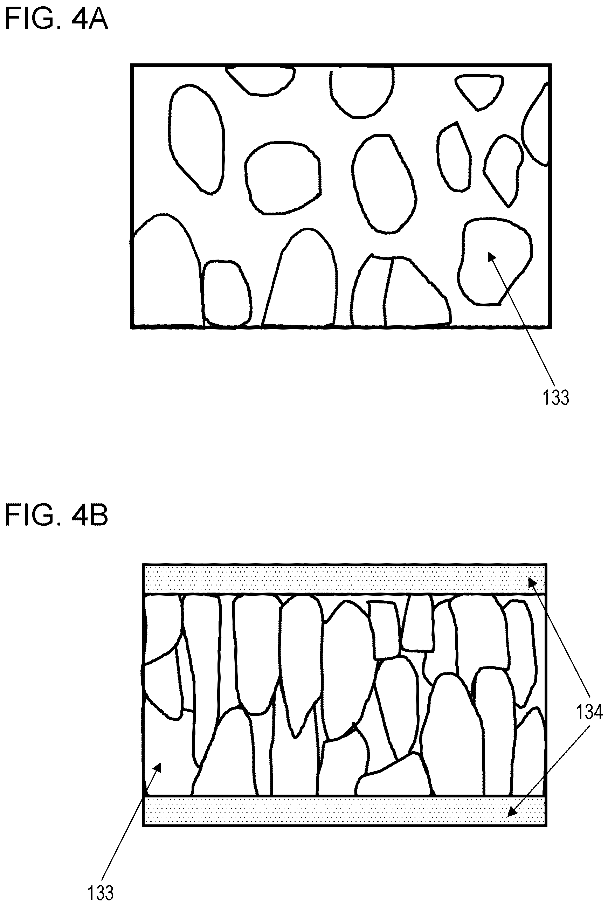

Fig. 3 shows a sectional view of the foamed member of the present invention in the horizontal direction (XY plane). Figs. 4A and 4B show side views of the foamed member of the present invention in a vertical direction (Z direction). Fig. 4A shows a side view of a foamed member without a skin layer on the surface, while Fig. 4B shows a side view of a foamed member with a skin layer on the surface.

The foamed member 122 includes siloxane bonds (Si-O-Si) made of silicon and oxygen, and the ratio N_{Q}/N_{D} of the number N_{Q} of Q units to the number N_{D} of D units is greater than or equal to 0.09 in silicon contained in the foamed member. When the foamed member includes siloxane bonds (Si-O-Si) made of silicon and oxygen, it is possible to decrease the glass transition temperature of the foamed member to below - 30°C to which the operating temperature ranges, so the physical properties of the foamed member, equivalent to those at room temperature, can be maintained even at low temperatures.

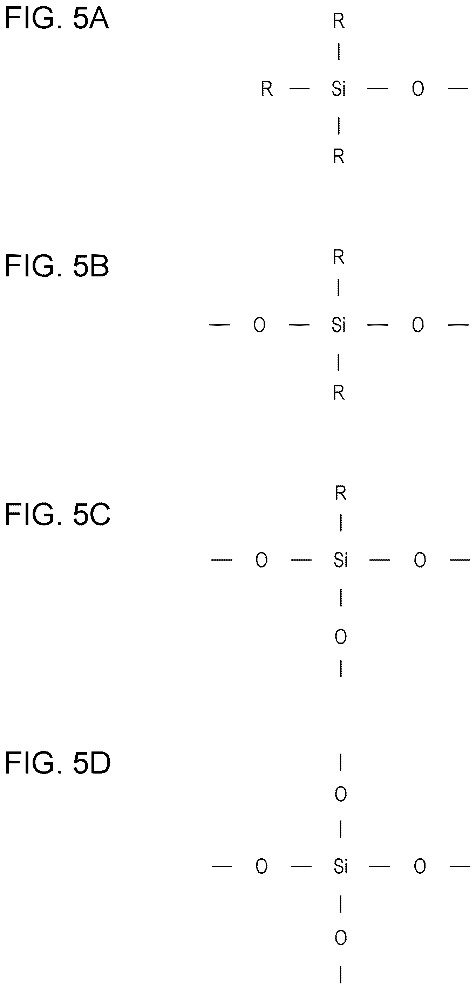

When the ratio N_{Q}/N_{D} of the number N_{Q} of Q units to the number N_{D} of D units in silicon contained in the foamed member is greater than or equal to 0.09, the driving efficiency of the vibration-type actuator can be improved. Here, the Q unit and D unit of silicon refer to the units that make up the skeletal structure of a molecule including siloxane bonds. As shown in Figs. 5A to 5D, Fig. 5A refers to a monofunctional unit with three organic substituents as M unit, Fig. 5B refers to a difunctional unit with two organic substituents as D unit, Fig. 5C refers to a trifunctional unit with one organic substituent as T unit, and Fig. 5D refers to a quad-functional unit with no organic substituents as Q unit. M units mean both ends of the backbone structure. D units exhibit flexibility in the skeletal structure, and T units and Q units exhibit rigidity in the skeletal structure.

In the foamed member, when the ratio N_{Q}/N_{D} of the number N_{Q} of Q units to the number N_{D} of D units in silicon contained in the foamed member is greater than or equal to 0.09, the foamed member is suitable as a vibration attenuation member, and the driving efficiency of the vibration-type actuator can be improved. On the other hand, when the ratio N_{Q}/N_{D} is less than 0.09, the flexibility of the foamed member is high, with the result that application of pressure to the vibrator by the urging member is not uniform, which may lead to a significant variation in characteristics and a decrease in driving efficiency, so it is undesirable.

T units may be present to make the skeletal structure rigid; however, it is preferable that the proportion of Q units be greater than the proportion of T units in order to hold the structural rigidity of the skeletal structure and ensure a stable structure over a long period. On the other hand, when the skeletal structure is too rigid, the skeletal structure hinders the vibrations of the vibrator, which become factors to cause the deterioration of the drive characteristics of the motor and factors to generate abnormal noises. Preferably, the ratio N_{Q}/N_{D} of the number N_{Q} of Q units to the number N_{D} of D units in silicon contained in the foamed member is less than or equal to 0.5. More preferably, the ratio N_{Q}/N_{D} is less than or equal to 0.29.

The constitutional units of silicon compounds contained in the foamed member can be identified through molecular structure analysis using solid-state nuclear magnetic resonance (hereinafter, referred to as solid-state NMR), and the ratio of the constitutional units can be calculated. The NMR method is a method of measuring the excitation energy of nuclear spin, and in the case of silicon compounds, information about the molecular structure can be obtained by observing the ²⁹Si nucleus.

There are two types of measurement methods for silicon compounds using the solid-state NMR method, that is, a dipolar decoupling (DD) method and a cross polarization (CP) method. The CP method provides a significantly different detection sensitivity depending on the crystallinity and the presence of nearby ¹H. Therefore, the integral ratio of the measured signals cannot accurately reflect the ratio of components. On the other hand, the DD method has lower sensitivity compared to the CP method and needs a long time for measurement; however, by optimally setting a measurement time, the ratio of components can be calculated from the integral ratio of the measured signals. The DD method needs to be used to calculate the constitutional units of silicon compounds contained in the foamed member of the present invention.

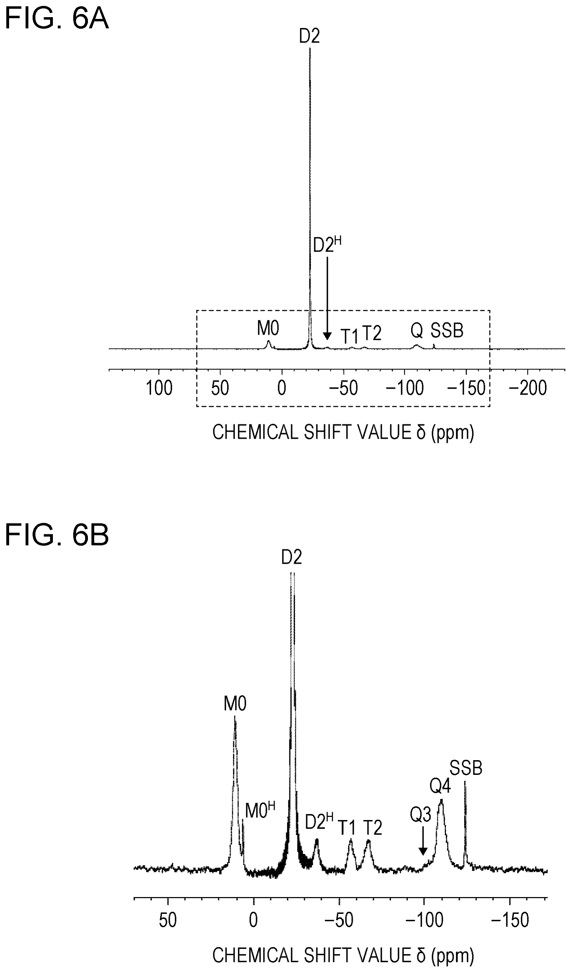

Fig. 6A shows an example of a ²⁹Si-DD-MAS NMR spectrum obtained through solid-state NMR of the foamed member in the vibration-type actuator of the present invention, and Fig. 6B is an enlarged view of the region surrounded by the dashed-line box in Fig. 6A. The abscissa axis of the NMR spectrum is called a chemical shift value δ (ppm), which is the value obtained by dividing a deviation from a reference resonance frequency by a reference frequency, and shows a unique value for each structure.

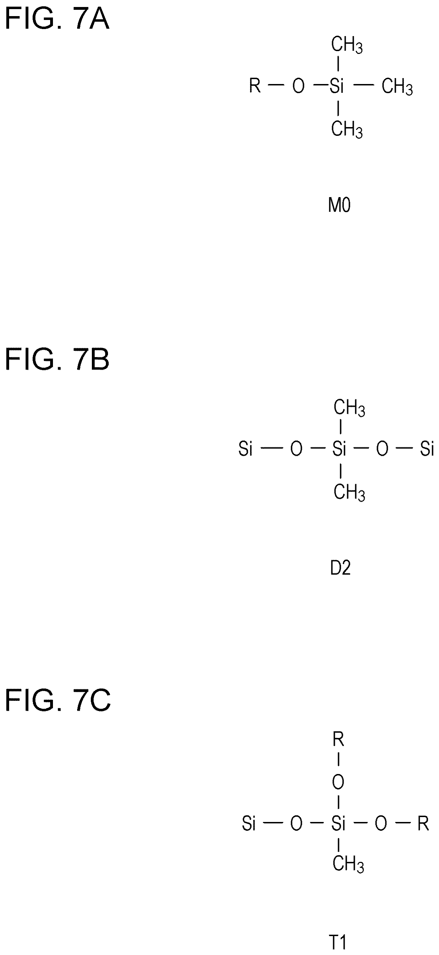

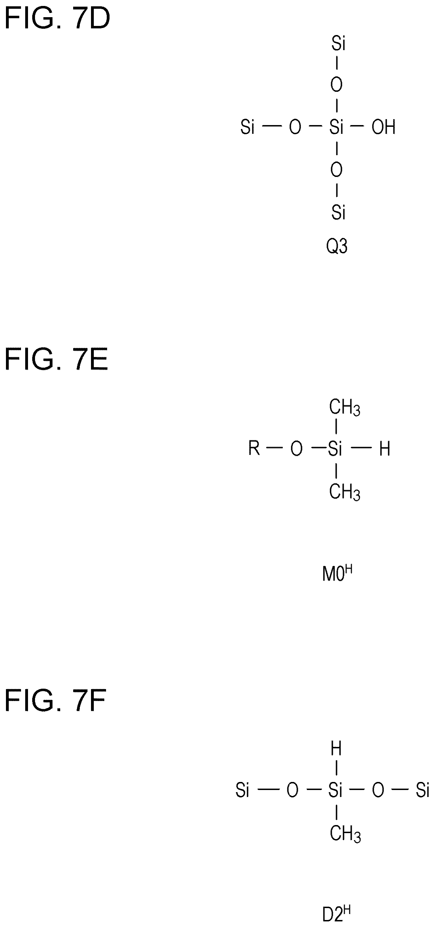

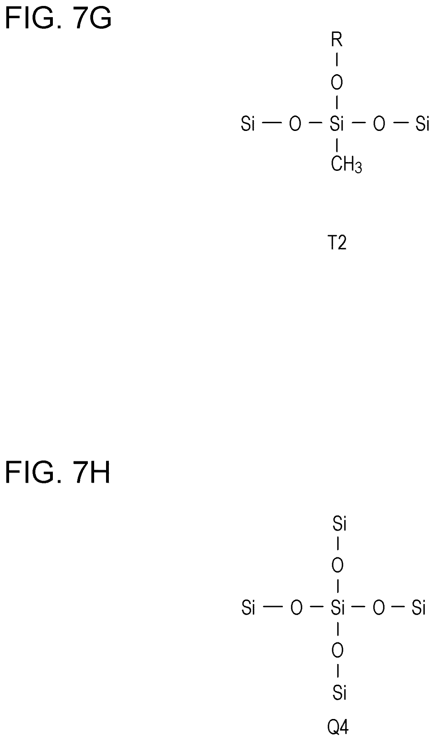

For example, the structure of Q4 in Fig. 6B can be identified because the peak of the NMR spectrum is present at a position of -110ppm. The SSB shown in Figs. 6A and 6B refers to the spinning sideband, which is a ghost signal detected due to the anisotropy of a molecular structure. The molecular structures respectively assigned to the peaks in Figs. 6A and 6B are shown in Figs. 7A to 7H. Various molecular structures are assigned depending on the differences in the types of elements and molecules that bond with the central Si. In the present invention, the molecular structures are classified into four categories, that is, M unit, D unit, T unit, and Q unit, and the ratio is calculated. In other words, in the molecular structures of Figs 7A to 7H, the peak area intensity is calculated using M units for M0 and M0^{H}, D units for D2 and D2^{H}, T units for T1 and T2, and Q units for Q3 and Q4.

In the NMR spectrum, the peaks for the M units can be found in the range from 20ppm to 0ppm, while the peaks for the D units can be found in the range from 0ppm to -45ppm. The peaks for the T units can be found in the range from - 45ppm to -85ppm, while the peaks for the D units can be found in the range from -85ppm to -120ppm.

The constitutional units including Q units and D units of silicon mean crosslinking points, and the ratio indicates a crosslink density. In a manufacturing process for a foamed member, by controlling the heating temperature and heating time during heat curing or curing through crosslinking reactions resulting from mixing of two liquid raw materials, it is possible to change the crosslink density and the average equivalent circle diameter of air bubbles in the foamed member. A foamed member was obtained by subjecting a foamed material containing silicone resin with air bubbles having an average equivalent circle diameter greater than or equal to 120 µm to heat treatment held at a temperature higher than or equal to 60°C and lower than or equal to 80°C under a pressure higher than or equal to 600 g/cm² and lower than or equal to 700 g/cm². It is considered preferable that the structure of the foamed member stabilizes by performing heat treatment under pressure.

The foamed member is preferably sponge containing silicone rubber. Equivalent effects can be obtained from materials in which some of the methyl groups in silicone rubber are substituted with vinyl groups or substituted with phenyl groups. Silicone sponge is preferred because silicone sponge has a small volume change in the thickness direction under pressure and is excellent in long-term stability compared to felt. When, for example, felt is held in a pressurized state higher than or equal to 600 g/cm² and lower than or equal to 700 g/cm² at room temperature for 500 hours, the thickness compresses to about 50% and does not recover even after the pressure is released. On the other hand, silicone sponge has a small volume change because silicone sponge restores to nearly its original thickness when the pressure is released.

The characteristic is that the average equivalent circle diameter of air bubbles contained in the foamed member is greater than 120 µm. The average equivalent circle diameter of air bubbles contained in the foamed member 122 is preferably greater than 120 µm. The presence of air bubbles in the foamed member allows the foamed member to have spring properties. The foamed member can enable the vibrator 110 to uniformly apply pressure to the contact body 104 and can also function as a vibration attenuation member.

The average equivalent circle diameter is preferably calculated from the cross-sectional shape of the foamed member. The average equivalent circle diameter of air bubbles in the cross-section of the foamed member is greater than 120 µm, so it is possible to uniformly apply pressure to the vibrator while maintaining the drive characteristics of the motor without hindering the vibrations of the vibrator.

The average equivalent circle diameter of the foamed member 122 can be determined from a cross-sectional image obtained through cross-section observation using a method, such as image processing. To observe the cross-section, for example, a method in which the cross-section of a sample is exposed by cutting or the like and then the cross-section is observed with an optical microscope, a laser microscope, or the like, can be used. Another method is to obtain tomographic pictures through non-destructive X-ray CT scanning. As long as it is possible to examine the shapes of the air bubbles, the surface that is in contact with the electromechanical energy conversion element 120 may be treated as a cross-sectional shape. Both image processing software optimized for a microscope and commercially available image processing software can be used. Since there are air bubbles of various sizes, it is preferable to observe many air bubbles when calculating the average equivalent circle diameter. Specifically, it is preferable to calculate the average equivalent circle diameter from 50 or more air bubbles.

The foamed member of the present invention may have air bubbles in a columnar shape as shown in Fig. 4B or may have a skin layer on the surface of the foamed member. As shown in Fig. 4B, when a skin layer is present on the surface, it is difficult to accurately examine air bubbles from the surface, so it is preferable to expose the cross-section by cutting. The average equivalent circle diameter can be calculated through image processing of the obtained cross-sectional picture.

The air bubbles of the foamed member preferably mainly include independent air bubbles. An independent air bubble refers to an air bubble that does not connect the front and back sides of the foamed member. Independent bubbles are difficult to pass gas and liquid through. For this reason, in order for the foamed member to have spring properties, air bubbles are independent air bubbles. On the other hand, continuous air bubbles are air bubbles connected, so air easily enters and exits, and the air bubbles are prone to collapse when pressure is applied. There are concerns that pressure cannot be uniformly applied to the vibrator due to poor spring properties, and the vibration attenuation function decreases, so it is not preferable. The number of independent air bubbles is preferably greater than the number of interconnected air bubbles, that is, the number of independent air bubbles in the number of air bubbles contained in the foamed member is preferably higher than or equal to 50%. At this time, it is possible to count the number of air bubbles from a cross-sectional picture containing 50 or more air bubbles.

The average equivalent circle diameter of the air bubbles in the foamed member is preferably greater than or equal to 200 µm. To achieve stable operation within the operating temperature range (for example, -30°C to 60°C) of the vibration-type actuator, it is effective to use a piezoelectric material with a phase transition temperature lower than or equal to -10°C in the vibration-type actuator. In other words, it is effective to use a piezoelectric material, of which the piezoelectric characteristics at - 10°C are higher than the piezoelectric characteristics at room temperature, in the vibration-type actuator. At this time, when the average equivalent circle diameter of the air bubbles is set so as to be greater than or equal to 200 µm, it is possible to maintain the effect as a vibration attenuation member in a low-temperature range and improve driving efficiency. The average equivalent circle diameter of the air bubbles is more preferably greater than or equal to 300 µm.

The average equivalent circle diameter of the foamed member is preferably less than than half the thickness t of the foamed member. By doing so, the foamed member can uniformly apply pressure to the vibrator and function as a vibration attenuation member. More preferably, the foamed member with an average equivalent circle diameter less than 1/3 of the thickness t of the foamed member is adopted.

### (Contact Body)

The contact body 104 is preferably made of stainless steel from the viewpoint of rigidity. Among stainless steels, martensitic stainless steel is preferable, and SUS420J2 is the most preferable. The contact body 104 needs to have high wear resistance because the contact body 104 is in friction contact with the elastic body 103, and the surface is subjected to nitriding or anodizing. A frictional force due to pressure contact acts between the protruding portions 106 and the contact body 104. The vibrations generated by the electromechanical energy conversion element 120 cause the tips of the protruding portions 106 to vibrate elliptically, to generate the driving force (thrust) that drives the contact body 104. The contact body is generally called a slider or a rotor.

The term "contact body" refers to a member that is in contact with a vibrator and moves relatively to the vibrator due to the vibrations generated in the vibrator. The contact between the contact body and the vibrator is not limited to direct contact without any other member interposed between the contact body and the vibrator. The contact between the contact body and the vibrator may be indirect contact where another member is interposed between the contact body and the vibrator, as long as the contact body moves relative to the vibrator due to the vibrations generated in the vibrator. "Another member" is not limited to a member that is independent of the contact body and the vibrator (for example, a high-friction material made of a sintered body). "Another member" may be a surface treatment part formed by plating, nitriding, or the like, on the contact body or the vibrator.

### (Piezoelectric Vibrator)

In the annular piezoelectric element, the piezoelectric materials that are respectively in contact with the adjacent drive phase electrodes are polarized with different polarities, so, when an electric field of the same polarity is applied to the drive phase electrodes 101e, the elongation and shrinkage polarities in those regions of the piezoelectric materials reverse alternately with a pitch of λ/2. When an alternating voltage is applied to the first electrode 101a, a first standing wave with a wavelength λ occurs across the entire circumference of the vibrator. Even when an alternating voltage is applied to the second electrode 101b, a second standing wave is similarly generated; however, the position of the wave is rotationally shifted in the circumferential direction by λ/4 relative to the first standing wave. On the other hand, when two types of alternating voltages with the same frequency and a temporal phase difference of n/2 are applied to the first and second electrodes, the following progressive wave occurs. In other words, as a result of the synthesis of the first and second standing waves, a progressive wave (wave number n and wavelength λ along the ring) of bending vibration (vibration with an amplitude perpendicular to the surface of the vibrator) propagating in the circumferential direction occurs over the entire circumference in the vibrator.

When a bending vibration progressive wave (hereinafter, which may be simply referred to as "bending vibration wave") occurs, each point on the surface of a vibration plate that makes up the vibrator moves elliptically, so a moving object that is in contact with this surface rotates upon receiving a frictional force (driving force) in the circumferential direction from the vibration plate. The rotation direction can be reversed by switching the sign of the phase difference between the alternating voltages respectively applied to the first electrode and the second electrode. The rotation speed can be controlled by the frequency and amplitude of each of the alternating voltages respectively applied to the first electrode and the second electrode.

Figs. 2A and 2B illustrate two vibration modes generated by the vibrator of the present invention, including the rectangular piezoelectric material. The first electrode 101a and the second electrode 101b are provided on the rectangular piezoelectric material, and those regions are referred to as a first region and a second region.

· Mode A When both the first region and the second region elongate or shrink, the first bending vibration mode (mode A) occurs. Mode A is most strongly excited when the phase difference between the alternating voltages VA and VB respectively applied to the first electrode 101a and the second electrode 101b is 0° and the frequency is near the resonance frequency of Mode A. Mode A is a first-order out-of-plane vibration mode where two nodes (where the amplitude is minimum) appear approximately parallel to the long sides of the vibrator 110. The two protruding portions 106 that protrude in the same direction in the elastic body are disposed near the positions of the antinodes (where the amplitude is maximum) in Mode A. Therefore, the end faces of the protruding portions 106 move reciprocally in the Z direction due to the vibration mode A.
· Mode B When the first region elongates and shrinks while the second region shrinks and elongates, a second bending vibration mode (Mode B) occurs. Mode B is most strongly excited when the phase difference between the alternating voltages VA and VB respectively applied to the first electrode 101a and the second electrode 101b is 180° and the frequency is near the resonance frequency of Mode B. Mode B is a second-order out-of-plane vibration mode where three nodes appear approximately parallel to the short sides of the vibrator 110. The protruding portions 106 of the elastic body are disposed near the positions of the nodes of Mode B. Therefore, the end faces of the protruding portions 106 move reciprocally in the X direction due to Mode B.

In the vibration-type actuator 100, when the phase difference between the alternating voltages VA and VB ranges from 0 to ±180°, Mode A and Mode B are excited simultaneously, and the protruding portions 106 of the elastic body are excited to elliptically vibrate. The vibration-type actuator that is driven in Mode A and Mode B using the rectangular piezoelectric material is preferable because it is easily downsized.

More preferably, two protruding portions that protrude in the same direction are present out of the plane of the plate portion. It is preferable because the vibration-type actuator that is driven in Mode A and Mode B using the rectangular piezoelectric material as shown in Figs. 2A and 2B is easily downsized.

To prevent hinder of vibration caused by the deformation of the foamed member due to application of pressure, it is preferable that the area of a portion where the foamed member and the electromechanical energy conversion element contact with each other be less than the area of a planar portion of the electromechanical energy conversion element that includes the above portion. It is preferable that the foamed member be smaller than the electromechanical energy conversion element. It is expected to suppress the inconvenience that the foamed member wraps around the side of the foamed member and piezoelectric element that is the electromechanical energy conversion element due to the deformation of the foamed member to hinder the vibration of the piezoelectric element or interferes with the peripheral member to hinder the vibration. It is also preferable that the foamed member be smaller than the elastic body. When the foamed member is larger than the elastic body, the foamed member may deform and interfere with the peripheral member to hinder vibration. Therefore, it is expected that reducing the size of the foamed member compared to the elastic body reduces the inconvenience that the vibration is hindered.

### (Composition of Piezoelectric Material)

The composition of the piezoelectric material 102 is not limited as long as the piezoelectric material 102 can be used in a vibration-type actuator.

The piezoelectric materials used as piezoelectric materials are generally lead zirconate titanate (PZT)-based materials. However, from the viewpoint of recent concerns regarding the influence of lead on environments, it is more preferable that the piezoelectric materials be made of perovskite-type metal oxides that do not contain lead (the content of lead is less than 1000ppm). The content of lead can be measured, for example, by ICP optical emission spectroscopy.

The main component of piezoelectric material not containing lead, that is, lead-free piezoelectric material, is preferably a barium titanate-based material.

The piezoelectric material is preferably made of a barium titanate-based material from the viewpoint that the barium titanate-based material has a high piezoelectric constant and is relatively easy to manufacture. Here, examples of the barium titanate-based material include barium titanate (BaTiO₃), barium calcium titanate ((Ba,Ca)TiO₃), barium zirconate titanate (Ba(Ti,Zr)O₃), and barium calcium zirconate titanate ((Ba,Ca) (Ti,Zr)O₃). Examples of the barium titanate-based material include compositions, such as sodium niobate-barium titanate (NaNbO₃-BaTiO₃), sodium bismuth titanate-barium titanate, and potassium bismuth titanate-barium titanate. The barium titanate-based material refers to materials that contain these compositions as main components. A main component refers to a case where the weight fraction of the material is higher than 10%.

Furthermore, piezoelectric materials containing these compositions as main components or in a composite form can be used in the vibration-type actuator 100 of the present invention.

The following materials are even more preferable from the viewpoint of excellent temperature dependence of piezoelectric characteristics within an operating temperature range and compatibility between the piezoelectric constant and mechanical quality factor of piezoelectric materials. In other words, it is preferable that barium calcium zirconate titanate ((Ba,Ca) (Ti,Zr)O3) and sodium niobate-barium titanate (NaNbO₃-BaTiO₃) be used as main components.

It is preferable that the main component of the piezoelectric material is barium calcium zirconate titanate (hereafter, referred to as BCTZ). When BCTZ is a main component, the piezoelectricity of BCTZ can be adjusted according to the application by adjusting the amounts of Ca and Zr. It is also possible to reduce the amount of use of expensive niobium.

Preferably, the piezoelectric material is a piezoelectric material containing an oxide with a perovskite-type structure containing Ba, Ca, Ti, and Zr, and Mn,
where the molar ratio x of Ca to the sum of Ba and Ca satisfies 0.02 ≤ x ≤ 0.30, the molar ratio y of Zr to the sum of Ti and Zr satisfies 0.020 ≤ y ≤ 0.095, and y ≤ x,
the ratio α of the molar amount of Ba and Ca to the molar amount of Ti and Zr satisfies 0.9955 ≤ α ≤ 1.01, and the content of Mn relative to 100 parts by weight of the oxide is greater than or equal to 0.02 parts by weight and less than or equal to 1.0 parts by weight in terms of metal equivalent.

Such piezoelectric materials can be represented by the following general formula (1).

(Ba₁₋ₓCaₓ)_{α}(Ti_{1-y}Zr_{y})O₃ (1)

where, preferably,
a perovskite-type metal oxide represented by
0.986 ≤ α ≤ 1.100,
0.02 ≤ x ≤ 0.30, and
0.02 ≤ y ≤ 0.095 is used as a main component, and the content of metal components other than the main component, contained in the piezoelectric material, is less than or equal to one part by weight relative to 100 parts by weight of the metal oxide in terms of metal equivalent.

In particular, preferably, the metal oxide contains Mn, and the content of Mn is greater than or equal to 0.02 parts by weight and less than or equal to 0.40 parts by weight relative to the 100 parts by weight of the metal oxide in terms of metal equivalent. When the metal oxide contains Mn in the above range, the insulation property and the mechanical quality factor Qm improve. Here, the mechanical quality factor Qm is a factor that represents the elastic loss due to vibration when piezoelectric materials are evaluated as vibrators, and the magnitude of the mechanical quality factor is observed as the sharpness of a resonance curve in impedance measurement. In other words, the mechanical quality factor Qm is a constant that represents the sharpness of resonance of the vibrator. When the mechanical quality factor Qm is large, the strain of the piezoelectric material becomes greater near the resonance frequency, so it is possible to effectively vibrate the piezoelectric material.

The metal oxides represented by the general formula (1) mean that the metal elements positioned at the A site of the perovskite structure are Ba and Ca and the metal elements positioned at the B site are Ti and Zr. However, some Ba and Ca may be positioned at the B site. Similarly, some Ti and Zr may be positioned at the A site.

In the general formula (1), the molar ratio of the B-site elements to the O element is one to three; however, even when the molar ratio slightly deviates, the metal oxide is included in the scope of the present invention as long as the metal oxide has a perovskite structure as a main phase.

The fact that the metal oxide has a perovskite structure can be determined, for example, through structural analysis using X-ray diffraction or electron diffraction.

x that represents the molar ratio of Ca at the site A in the general formula (1) satisfies the range of 0.02 ≤ x ≤ 0.30. When a portion of Ba in perovskite-type barium titanate is substituted with Ca within a certain range, the phase transition temperature between orthorhombic phase and tetragonal phase shifts to a lower temperature side, so stable piezoelectric vibrations can be obtained within the drive temperature range of the vibration-type actuator. However, when x is greater than 0.30, the piezoelectric constant of the piezoelectric material is not enough, so the performance of the vibration-type actuator may be insufficient. On the other hand, when x is less than 0.02, the dielectric loss (tanδ) may increase. As the dielectric loss increases, heat generation at the time when the vibration-type actuator is driven by applying voltage to the piezoelectric material increases, so the motor driving efficiency may decrease and power consumption may increase.

In the general formula (1), y that represents the molar ratio of Zr at the B site satisfies the range of 0.02 ≤ y ≤ 0.1. When y is greater than 0.1, Td is low, that is, Td is lower than 80°C, with the result that the temperature range in which the vibration-type actuator can be used is lower than 80°C, which is not preferable.

In the specification, Td refers to the lowest temperature among temperatures at which, after a piezoelectric material has been subjected to polarization for a week, the piezoelectric material is heated from room temperature to Td, and then cooled back to room temperature, the piezoelectric constant decreases by more than 100 compared to the piezoelectric constant before heating.

Preferably, in the general formula (1), α that represents the ratio of the molar amount of Ba and Ca at the A site to the molar amount of Ti and Zr at the B site satisfies the range of 0.9955 ≤ α ≤ 1.010. When α is smaller than 0.9955, abnormal grain growth easily occurs in the crystal grains that constitute the piezoelectric material, so the mechanical strength of the piezoelectric material decreases. On the other hand, when α is larger than 1.010, the piezoelectric material does not densify, and its insulation property becomes significantly brittle.

Devices and methods for measuring the composition of the piezoelectric material are not limited. Examples of the devices and methods include X-ray fluorescence analysis, ICP optical emission spectroscopy, and atomic absorption spectroscopy. Using any measurement method, the weight ratio and composition ratio of the elements contained in the piezoelectric material can be calculated.

The metal equivalent indicating the content of Mn is as follows. The contents of metals Ba, Ca, Ti, Zr, and Mn, measured from the piezoelectric material through X-ray fluorescence analysis (XRF), ICP optical emission spectroscopy, atomic absorption spectroscopy, or the like, are calculated. The metal equivalent indicates a value represented by the ratio of the weight of Mn to the total weight set to 100 when the elements that constitute the metal oxide represented by the general formula (1) are converted to oxide basis based on the contents of the metals.

When the content of Mn is less than 0.02 parts by weight, the effect of the polarization necessary for driving the vibration-type actuator may be insufficient. On the other hand, when the content of Mn is greater than 0.40 parts by weight, the piezoelectric characteristics of the piezoelectric material may be insufficient, or a hexagonal crystal structure without piezoelectric characteristics may appear. Mn is not limited to metal Mn; it is sufficient that Mn is just contained in the piezoelectric material as an Mn component, and how Mn is contained in the piezoelectric material does not matter. For example, Mn may be formed as a solid solution at the B site or may be contained at grain boundaries. A more preferable containing form is to be formed as a solid solution at the B site from the viewpoint of insulation property and sinterability.

It is preferable that the piezoelectric material contain Bi in an amount greater than or equal to 0.042 parts by weight and less than or equal to 0.850 parts by weight in terms of metal equivalent.

The piezoelectric materials may contain up to 0.85 parts by weight of Bi in terms of metal equivalent relative to 100 parts by weight of the metal oxide represented by the general formula (1). The content of Bi in the metal oxide can be measured, for example, by ICP optical emission spectroscopy. Bi may be present at the grain boundaries of ceramic piezoelectric material or may be formed as a solid solution in the perovskite-type structure of (Ba,Ca)(Ti,Zr)O₃. When Bi is present at the grain boundaries, the friction between particles is reduced, and the mechanical quality factor increases. On the other hand, when Bi is incorporated into a solid solution that forms a perovskite structure, the phase transition temperature decreases, with the result that the temperature dependence of the piezoelectric constant reduces and the mechanical quality factor further improves. When the position where Bi is incorporated into the solid solution is at the A site, it is preferable because the charge balance with Mn improves.

The piezoelectric material may contain components (hereinafter, referred to as accessory components) other than the elements included in the general formula (1), Mn, and Bi within a range where the characteristics do not vary. It is preferable that the total of the accessory components be less than 1.2 parts by weight relative to 100 parts by weight of the metal oxide represented by the general formula (1). When the accessory components exceed 1.2 parts by weight, the piezoelectric characteristics and insulation characteristics of the piezoelectric material may decrease. Since lead-free piezoelectric materials have high Young's modulus, the lead-free piezoelectric materials tend to have a higher resonance frequency compared to lead-based piezoelectric materials. When the resonance frequency is high, the number of vibrations of the vibrator increases, so it is sensitive to changes in the vibration attenuation member disposed between the urging member and the vibrator. Therefore, in the vibration-type actuator using a lead-free piezoelectric material, it is preferable to use a foamed member that has excellent long-term stability and small changes.

The phase transition temperature is more preferably lower than or equal to -10°C because the piezoelectric material exhibits excellent temperature dependence of the piezoelectric characteristics within the operating temperature range (for example, -30°C to 60°C) of the vibration-type actuator.

The piezoelectric material of the present invention undergoes a sequential phase transition from tetragonal phase to orthorhombic phase as the temperature is reduced from room temperature. The phase transition temperature referred to in the specification indicates this phase transition. The phase transition temperature is calculated as a temperature at which a value obtained by differentiating a dielectric constant, measured while changing the temperature, with respect to a sample temperature is maximum. A crystal system can be evaluated using X-ray diffraction, electron diffraction, or Raman scattering. Near the phase transition temperature, the dielectric constant and the electromechanical coupling coefficient become maximum, and the Young's modulus becomes minimum. The piezoelectric constant is a function of these three parameters and shows a maximum value or an inflection point near the phase transition temperature.

### (Manufacturing Method for Vibration-Type Actuator)

The vibration-type actuator of the present invention is manufactured by the following manufacturing method. First, a foamed material that has air bubbles with an average equivalent circle diameter of greater than 120 µm and that contains silicone rubber is subjected to pressurized heat treatment to obtain a foamed member. Subsequently, an elastic body and an electromechanical energy conversion element are brought into contact with each other to obtain a vibrator, and a contact body is prepared. Finally, by urging the vibrator toward the contact body via the foamed member, a vibration-type actuator is obtained. The pressurized heat treatment includes a process of holding the foamed material at a temperature higher than or equal to 60°C and lower than or equal to 80°C under a pressure higher than or equal to 600 g/cm² and lower than or equal to 700 g/cm².

### (Electronic Device)

An electronic device of the present invention includes the vibration-type actuator of the present invention, a member connected to the contact body of the vibration-type actuator, and a member position detector (for example, an encoder). The electronic device can precisely control the position of a member by detecting the position of the member and operating the vibration-type actuator until the member reaches a target position.

### (Optical Apparatus)

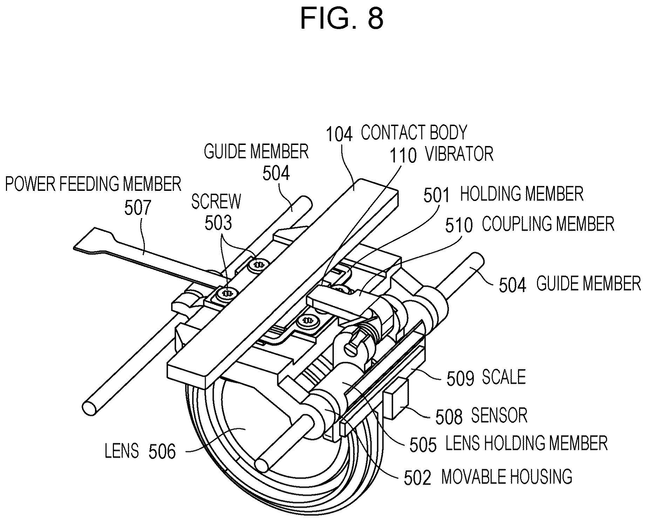

The optical apparatus of the present invention includes the electronic device of the present invention and at least one of an optical element and an image pickup element. Fig. 8 is a schematic view showing an embodiment of an optical apparatus (a focus lens unit of a lens barrel device) of the present invention. In Fig. 8, the vibrator 110 including a rectangular piezoelectric material is in contact with the contact body (slider) 104 under pressure, as in the case of Fig. 1D. A power feeding member 507 is connected to the surface side where the first region and the second region are provided. When a desired voltage is applied to the vibrator 110 via the power feeding member 507 by a voltage input unit (not shown), the protruding portions of the elastic body (when not shown) elliptically move. A holding member 501 is joined to the vibrator 110 and is configured to inhibit unnecessary vibrations. A movable housing 502 is fixed to the holding member 501 by screws 503 and is integrated with the vibrator 110. The electronic device of the present invention is formed of these members. By attaching the movable housing 502 to guide members 504, the electronic device of the present invention can move in a straight line in both directions (in the forward and backward directions) along the guide members 504.

Next, a lens 506 (optical member) that serves as a role of the focus lens of the lens barrel device will be described. The lens 506 is fixed to a lens holding member 505, and has an optical axis (not shown) parallel to the moving direction of the vibration-type actuator. The lens holding member 505, as in the case of the vibration-type actuator, performs focus position adjustment (focus operation) by moving in a straight line on the two guide members 504 (described later). The two guide members 504 are members that fit the movable housing 502 and the lens holding member 505 and allow the movable housing 502 and the lens holding member 505 to move in a straight line. With this configuration, the movable housing 502 and the lens holding member 505 can move in a straight line on the guide members 504.

A coupling member 510 is a member that transmits the driving force generated by the vibration-type actuator to the lens holding member 505, and is fitted and attached to the lens holding member 505. As a result, the lens holding member 505 can smoothly move in both directions along the two guide members 504 together with the movable housing 502.

A sensor 508 is provided to detect the position of the lens holding member 505 on the guide members 504 by reading the positional information of a scale 509 affixed to the side of the lens holding member 505. As described above, the focus lens unit of the lens barrel device is constructed by incorporating the above-described members.

In the above description, the lens barrel device for a single-lens reflex camera has been described as an optical apparatus; however, it is also applicable to various optical apparatuses with vibration-type actuators, regardless of the type of camera, including a compact camera where a lens and a camera main body are integrated, and an electronic still camera.

As another configuration of the vibration-type actuator, a plurality of vibrators may be in contact with a common contact body together, and the contact body may be disposed so as to be movable relative to the plurality of vibrators due to the vibrations of the plurality of vibrators.

As application examples of the vibration-type actuator of the present invention, application to the medical or engineering field is conceivable. Specifically, a wire driving actuator that includes an elongated member, a wire that is inserted through the elongated member and fixed to part of the elongated member, and the above-described vibration-type actuator that drives the wire, and the elongated member bends by driving the wire.

### [Examples]

Next, the vibration-type actuator and vibrator of the present invention will be described by way of examples; however, the present invention is not limited to the following examples.

### (Example 1)

Metal oxide powder was fired at 1340°C to obtain the piezoelectric material shown in manufacturing composition 1 in Table 2.

The manufacturing composition 1 is the composition represented by the general formula (1), and the values of x, y, and α shown in Table 2 correspond to the values of the above-described general formula (1).

The obtained piezoelectric material was substantially uniformly ground and polished to a thickness of 0.5 mm, and then machined into an annular shape with an outside diameter of 62 mm × an inside diameter of 54 mm. The drive phase electrodes 101e and the non-drive phase electrodes 101f shown in Fig. 1C were formed on one side of the shaped piezoelectric material 102. The electrodes were formed by applying silver paste to the piezoelectric material 102 using screen printing and drying and baking the silver paste.

Subsequently, an adhesive was applied to the elastic body 103 made of SUS420J2, and the elastic body 103 was joined by compression bonding to the piezoelectric material 102 on which the electrodes were formed. The annular piezoelectric material and the annular elastic body were disposed such that the centers of the respective circles coincide with each other using a positioning jig. Subsequently, heat treatment for curing the adhesive was performed. The piezoelectric material to which the elastic body was joined by compression bonding was heated to a temperature of T1 = 160°C and held for 180 seconds, then cooled to room temperature, and the pressure was released to obtain a vibrator. Subsequently, an FPC to which ACP was applied was joined by thermal compression bonding to the electrodes provided on the piezoelectric material. The conditions for thermal compression bonding are that a temperature of T2 is 140°C and a holding time is 20 seconds.

After that, SUS420J2, that is, the elastic body, was grounded, and voltages with different polarities were alternately applied to the adjacent drive phase electrodes 101e for polarization. In the polarization, a plurality of external electrodes connected to a power supply are brought into contact with the electrodes used as a sensor, between the drive phase electrodes 101e and the driven phase electrodes 101f. After that, the product was heated to T3 = 100°C, and then an electric field equivalent to 2 kV/mm was applied to the product for 30 minutes. After that, the product was cooled to 40°C over 40 minutes while maintaining the applied electric field, and then application of the voltage was terminated.

Subsequently, the first electrode 101a and the second electrode 101b were printed and dried to obtain a vibrator. In a drying process, the temperature of the piezoelectric material is kept below 80°C to inhibit depolarization of the piezoelectric material. A vibration-type actuator was manufactured by bringing the obtained vibrator in contact with the contact body (rotor) made of SUS420J2 under pressure. The type of foamed member that includes siloxane bonds (Si-O-Si) made of silicon and oxygen and that is installed between the electromechanical energy conversion element and the urging member is shown in Example 1 of Table 1. The ratio N_{Q}/N_{D} of the number N_{Q} of Q units to the number N_{D} of D units in silicon contained in the foamed member was 0.23.

### (Example 2)

As in the case of Example 1, the piezoelectric material shown in manufacturing composition 1 was obtained. The obtained piezoelectric material was uniformly ground and polished to a thickness of 0.35 mm, and then machined into a rectangle of 8.9 mm × 5.7 mm. The first to third electrodes shown in Fig. 3 were formed on both sides of the shaped piezoelectric material using the same method as in Example 1.

Subsequently, an adhesive was applied to the elastic body made of SUS420J2, and the elastic body was joined by compression bonding to the rectangular piezoelectric material on which the electrodes were formed. The elastic body used had a larger rectangular portion of 9.1 mm × 5.8 mm than the piezoelectric material, and the thickness of the elastic body ranged from 0.25 mm to 0.30 mm. The rectangular piezoelectric material and the elastic body were disposed such that the centers of the respective rectangular portions coincide with each other and the edges of the rectangular portions are parallel to each other using a positioning jig. The piezoelectric material in a compression bonded state was heated to a temperature of T1 = 160°C and held for 180 seconds, then cooled to room temperature, and the pressure was released to obtain a vibrator.

Subsequently, an FPC to which ACP was applied and the piezoelectric material were joined by compression bonding for 20 seconds with a trowel at a temperature of T2 = 140°C, to join the FPC by thermal compression bonding to the electrodes provided on the piezoelectric material.

Subsequently, the piezoelectric material was subjected to polarization. In the polarization, the elastic body was grounded, and external electrodes connected to a power supply were respectively brought into contact with a first electrode and a second electrode. The FPC was already connected to the first electrode and the second electrode; however, the entire first electrode and second electrode are not covered by the FPC, and the external electrodes for polarization contact with the exposed parts. After that, the product was heated to T3 = 100°C, and then an electric field equivalent to 2 kV/mm was applied to the product for 30 minutes. After that, the product was cooled to 40°C over 40 minutes while maintaining the applied electric field, and then application of the voltage was terminated. A vibration-type actuator was manufactured by bringing the vibrator obtained through the above steps in contact with the contact body (slider) made of SUS420J2 under pressure. The type of foamed member that includes siloxane bonds (Si-O-Si) made of silicon and oxygen and that is installed between the electromechanical energy conversion element and the urging member is shown in Example 2 of Table 2.

**[Table 1]**

| | Piezoelectric Material | Foamed Member | | | | | | | | Drive Characteristics Rate of Change Relative to Comparative Example (%) | |
|---|---|---|---|---|---|---|---|---|---|---|---|
| | Shape | Type | Material | Ratio of Molecular Structure Where D Unit is 1 | | Average Equivalent Circle Diameter (µm) | Thickness (mm) | Skin Layer | Type of Air Bubbles | 20°C | |
| | | | | T Unit | Q Unit | | | | | Maximum Speed mm/s | Rated Power mW |
| Example 1 | Annular | Foamed Member A | Silicone Rubber | - | 0.230 | 320 | 2 | No | Independent Bubbles 50% or More | +20 | -10 |
| Example 2 | Rectangle | Foamed Member A | Silicone Rubber | - | 0.230 | 320 | 2 | No | Independent Bubbles | +20 | -10 |
| Example 3 | Rectangle | Foamed Member B | Silicone Rubber | - | 0.250 | 430 | 2 | No | Independent Bubbles | +20 | -8 |
| Example 4 | Rectangle | Foamed Member C | Silicone Rubber | - | 0.290 | 175 | 2 | No | Independent Bubbles 50% or More | 0 | -4 |
| Example 5 | Rectangle | Foamed Member D | Silicone Rubber | 0.061 | 0.118 | 205 | 2 | Yes | Independent Bubbles | 0 | -4 |
| Example 6 | Rectangle | Foamed Member E | Silicone Rubber | 0.061 | 0.090 | 210 | 1 | Yes | Independent Bubbles | 0 | 0 |

### (Example 3 to Example 6)

Except that the one shown in Table 1 is used for the type of foamed member containing siloxane bonds (Si-O-Si) made of silicon and oxygen and installed between the electromechanical energy conversion element and the urging member, the vibration-type actuators of Example 3 to Example 6 were manufactured using the same method as in Example 2.

### (Comparative Example 1)

Except that felt was installed between the electromechanical energy conversion element and the urging member, a vibration-type actuator was manufactured using the same method as in Example 1.

### (Comparative Example 2)

Except that felt was installed between the electromechanical energy conversion element and the urging member, a vibration-type actuator was manufactured using the same method as in Example 2.

### (Method of Evaluating Vibration-Type Actuator)

For the vibration-type actuators of Examples and Comparative Examples, a drive test was conducted by applying an alternating voltage with an amplitude of 130 Vpp to the first electrode and the second electrode. At that time, the phase difference in voltage between the first electrode and the second electrode was set to -90° and 90°.

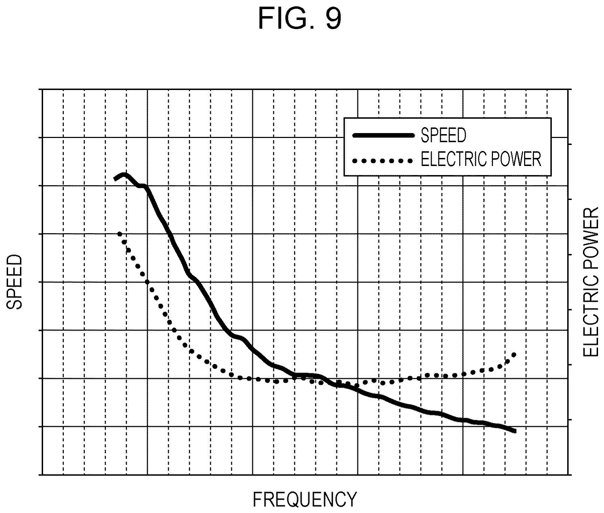

When the frequency of the alternating voltage is swept from a frequency higher than the resonance frequencies of vibration mode A and vibration mode B toward the resonance frequencies, the contact body is driven in the direction according to the phase difference of the alternating voltage and stops after reaching the maximum speed. For the sake of convenience, the traveling direction when the phase difference is -90° is referred to as the reverse traveling direction, and the traveling direction when the phase difference is 90° is referred to as the forward traveling direction. The maximum speed of the vibrator and the frequency at which the maximum speed was reached were measured with a sensor. An electric power (rated power) at a certain rated speed lower than the maximum speed was calculated from a current flowing through a drive circuit. Fig. 9 shows an example of the measurement results of speed and electric power against frequency. The maximum speed and rated power were measured in an environmental atmosphere of 20°C, and the average values in the reverse and forward travelling directions were calculated.

The change in maximum speed of Example 1 relative to the maximum speed of the vibration-type actuator manufactured in Comparative Example 1 and the change in rated power were calculated. Similarly, the changes in maximum speed of Example 3 to Example 6 relative to the maximum speed of the vibration-type actuator manufactured in Comparative Example 2 and the changes in rated power were calculated. The results are shown in Table 1.

In Example 1 and Example 2 using a foamed member A containing siloxane bonds (Si-O-Si) made of silicon and oxygen, compared to the vibration-type actuators of Comparative Example 1 and Comparative Example 2 using felt, the maximum speed increased, and the rated power decreased.

As shown in Example 3, it was confirmed that, with a foamed member B as well, the maximum speed increased and the rated power decreased at each temperature.

With a foamed member C shown in Example 4 and a foamed member D shown in Example 5, the maximum speed was equivalent to Comparative Examples; however, the rated power decreased.

With a foamed member E shown in Example 6, the maximum speed and the rated power were equivalent to those with felt of Comparative Example 2.

### (Example 7)

The vibration-type actuator manufactured in Example 2 was dynamically connected to an optical member to manufacture the optical apparatus shown in Fig. 8. The vibration-type actuator and the optical member connected to the vibration-type actuator were able to be precisely driven to a target position by controlling the alternating voltage applied to the piezoelectric material based on the position information provided from the encoder made up of a sensor and a scale. In the optical apparatus, it has been confirmed that an optical lens is connected to the vibration-type actuator and the vibration-type actuator has an autofocus function.

The above has been described using manufacturing composition 1 as an example. However, it has also been confirmed for manufacturing compositions 2 to 46 and lead zirconate titanate (PZT) that the drive characteristics of the vibration-type actuator of the present invention are equivalent to or better than felt as in the case of Example 2.

As described above, it has been found that, by providing a foamed member between the urging member and the vibrator, the ratio N_{Q}/N_{D} of the number N_{Q} of Q units to the number N_{D} of D units of silicon contained in the foamed member is preferably greater than or equal to 0.09. With this configuration, it is possible to provide a vibration-type actuator that has stable drive characteristics over a long period and improved drive characteristics in the vibration-type actuator.

**[Table 2]**

| | x | y | α | Mn Concentration (Parts by Weight) | Bi Concentration (Parts by Weight) |
|---|---|---|---|---|---|
| Manufacturing Composition 1 | 0.140 | 0.080 | 0.9985 | 0.140 | 0.000 |
| Manufacturing Composition 2 | 0.020 | 0.020 | 1.002 | 0.10 | 0.00 |
| Manufacturing Composition 3 | 0.095 | 0.060 | 1.001 | 0.08 | 0.00 |
| Manufacturing Composition 4 | 0.125 | 0.090 | 1.000 | 0.06 | 0.00 |
| Manufacturing Composition 5 | 0.095 | 0.030 | 1.002 | 0.08 | 0.00 |
| Manufacturing Composition 6 | 0.095 | 0.095 | 0.999 | 0.24 | 0.85 |
| Manufacturing Composition 7 | 0.110 | 0.075 | 0.9994 | 0.240 | 0.170 |
| Manufacturing Composition 8 | 0.110 | 0.075 | 0.9994 | 0.240 | 0.340 |
| Manufacturing Composition 9 | 0.110 | 0.075 | 0.9969 | 0.240 | 0.510 |
| Manufacturing Composition 10 | 0.110 | 0.075 | 0.9994 | 0.040 | 0.550 |
| Manufacturing Composition 11 | 0.120 | 0.080 | 0.9994 | 0.240 | 0.340 |
| Manufacturing Composition 12 | 0.125 | 0.020 | 1.003 | 0.08 | 0.00 |
| Manufacturing Composition 13 | 0.125 | 0.050 | 1.001 | 0.06 | 0.00 |
| Manufacturing Composition 14 | 0.130 | 0.075 | 0.9994 | 0.240 | 0.170 |
| Manufacturing Composition 15 | 0.140 | 0.075 | 1.003 | 0.02 | 0.00 |
| Manufacturing Composition 16 | 0.140 | 0.075 | 1.000 | 0.07 | 0.00 |
| Manufacturing Composition 17 | 0.140 | 0.075 | 1.001 | 0.08 | 0.00 |
| Manufacturing Composition 18 | 0.140 | 0.078 | 0.9955 | 0.160 | 0.181 |
| Manufacturing Composition 19 | 0.140 | 0.075 | 1.0004 | 0.160 | 0.094 |
| Manufacturing Composition 20 | 0.140 | 0.075 | 1.0004 | 0.160 | 0.189 |
| Manufacturing Composition 21 | 0.140 | 0.075 | 1.0004 | 0.160 | 0.239 |
| Manufacturing Composition 22 | 0.140 | 0.085 | 1.0004 | 0.160 | 0.539 |
| Manufacturing Composition 23 | 0.140 | 0.080 | 1.0004 | 0.140 | 0.289 |
| Manufacturing Composition 24 | 0.140 | 0.080 | 1.0004 | 0.140 | 0.339 |
| Manufacturing Composition 25 | 0.140 | 0.075 | 1.0004 | 0.160 | 0.094 |
| Manufacturing Composition 26 | 0.155 | 0.020 | 1.005 | 0.15 | 0.00 |
| Manufacturing Composition 27 | 0.155 | 0.065 | 1.000 | 0.02 | 0.00 |
| Manufacturing Composition 28 | 0.155 | 0.065 | 1.001 | 0.06 | 0.00 |
| Manufacturing Composition 29 | 0.155 | 0.069 | 1.004 | 0.18 | 0.00 |
| Manufacturing Composition 30 | 0.155 | 0.078 | 0.9994 | 0.240 | 0.170 |
| Manufacturing Composition 31 | 0.160 | 0.059 | 1.009 | 0.40 | 0.00 |
| Manufacturing Composition 32 | 0.160 | 0.078 | 1.0042 | 0.360 | 0.170 |
| Manufacturing Composition 33 | 0.160 | 0.085 | 0.9971 | 0.180 | 0.170 |
| Manufacturing Composition 34 | 0.170 | 0.075 | 0.9998 | 0.140 | 0.189 |
| Manufacturing Composition 35 | 0.170 | 0.075 | 1.0042 | 0.360 | 0.170 |
| Manufacturing Composition 36 | 0.175 | 0.090 | 1.007 | 0.10 | 0.00 |
| Manufacturing Composition 37 | 0.187 | 0.060 | 1.009 | 0.24 | 0.00 |
| Manufacturing Composition 38 | 0.187 | 0.060 | 1.010 | 0.40 | 0.00 |
| Manufacturing Composition 39 | 0.187 | 0.077 | 0.9994 | 0.240 | 0.170 |
| Manufacturing Composition 40 | 0.200 | 0.035 | 1.006 | 0.20 | 0.00 |
| Manufacturing Composition 41 | 0.200 | 0.090 | 1.006 | 0.26 | 0.00 |
| Manufacturing Composition 42 | 0.200 | 0.075 | 0.9994 | 0.240 | 0.170 |
| Manufacturing Composition 43 | 0.220 | 0.082 | 0.9994 | 0.240 | 0.170 |
| Manufacturing Composition 44 | 0.220 | 0.030 | 1.005 | 0.22 | 0.00 |
| Manufacturing Composition 45 | 0.260 | 0.070 | 1.005 | 0.28 | 0.00 |
| Manufacturing Composition 46 | 0.300 | 0.095 | 1.008 | 0.30 | 0.00 |

The disclosure of the present embodiment includes the following configurations and methods.

### (Configuration 1)

A vibration-type actuator includes: a vibrator including an electromechanical energy conversion element and an elastic body, the elastic body having a plate portion and protruding portions that protrude in the same direction out of a plane of the plate portion; a contact body that is in contact with the protruding portions of the vibrator and that moves relative to the vibrator; a foamed member that is in contact with the vibrator; and an urging member that urges the vibrator toward the contact body via the foamed member. The foamed member includes siloxane bonds, Si-O-Si, made of silicon and oxygen, and a ratio N_{Q}/N_{D} of the number N_{Q} of Q units to the number N_{D} of D units is greater than or equal to 0.09 in silicon contained in the foamed member.

### (Configuration 2)

In the vibration-type actuator according to Configuration 1, the foamed member is sponge containing silicone rubber.

### (Configuration 3)

In the vibration-type actuator according to Configuration 1 or 2, an average equivalent circle diameter of air bubbles of the foamed member is greater than 120 µm.

### (Configuration 4)

In the vibration-type actuator according to any one of Configurations 1 to 3, the electromechanical energy conversion element includes a piezoelectric material and electrodes, and a content of lead in the piezoelectric material is less than or equal to 1000ppm.

### (Configuration 5)

In the vibration-type actuator according to any one of Configurations 1 to 4, the plate portion has a rectangular shape.

### (Configuration 6)

In the vibration-type actuator according to any one of Configurations 1 to 5, the elastic body has two protruding portions.

### (Configuration 7)

In the vibration-type actuator according to any one of Configurations 1 to 6, the foamed member is smaller than the electromechanical energy conversion element.

### (Configuration 8)

In the vibration-type actuator according to any one of Configurations 1 to 7, the foamed member is smaller than the elastic body.

### (Configuration 9)

In the vibration-type actuator according to any one of Configurations 1 to 8, a main component of the electromechanical energy conversion element is a barium titanate-based material.

### (Configuration 10)

In the vibration-type actuator according to any one of Configurations 1 to 9, a main component of the electromechanical energy conversion element is barium calcium zirconate titanate.

### (Configuration 11)

An electronic device includes: a member and the vibration-type actuator according to any one of Configurations 1 to 10, provided on the member.

### (Configuration 12)

An optical apparatus includes: at least one of an optical element and an image pickup element; and the vibration-type actuator according to any one of Configurations 1 to 11, provided on the at least one of the optical element and the image pickup element.

### (Method 1)

A manufacturing method for a vibration-type actuator includes: a step of obtaining a foamed member by applying pressurized heat treatment to a foamed material having air bubbles with an average equivalent circle diameter greater than 120 µm and containing silicone rubber; a step of obtaining a vibrator by bringing an elastic body and an electromechanical energy conversion element into contact with each other; a step of preparing a contact body; and a step of obtaining a vibration-type actuator by urging the vibrator toward the contact body via the foamed member.

### (Method 2)

In the manufacturing method for a vibration-type actuator according to Method 1, the pressurized heat treatment includes a treatment of holding the foamed material at a temperature higher than or equal to 60°C and lower than or equal to 80°C under a pressure higher than or equal to 600 g/cm² and lower than or equal to 700 g/cm².

The present invention is not limited to the above-described embodiment. Various changes and modifications are applicable without departing from the spirit and scope of the present invention. Therefore, the following claims are attached to show the scope of the present invention.

This application claims the benefit of Japanese Patent Application No. 2023-096027 filed June 12, 2023, which is hereby incorporated by reference herein in its entirety.

### Reference Signs List

- 100: vibration-type actuator
- 101: electrode
- 101a: first electrode
- 101b: second electrode
- 101c: third electrode
- 101d: fourth electrode
- 101e: drive phase electrode
- 101f: non-drive phase electrode
- 102: piezoelectric material
- 103: elastic body
- 104: contact body
- 106: protruding portion
- 107: support portion
- 108: plate portion
- 110: vibrator
- 120: electromechanical energy conversion element
- 121: urging member
- 122: foamed member
- 133: air bubble
- 134: skin layer
- 501: holding member
- 502: movable housing
- 503: screw
- 504: guide member
- 505: lens holding member
- 506: lens
- 507: power feeding member
- 508: sensor
- 509: scale
- 510: coupling member

## Claims

1. A vibration-type actuator comprising:
a vibrator including an electromechanical energy conversion element and an elastic body, the elastic body having a plate portion and protruding portions that protrude in the same direction out of a plane of the plate portion;
a contact body that is in contact with the protruding portions of the vibrator and that moves relative to the vibrator;
a foamed member that is in contact with the vibrator; and
an urging member that urges the vibrator toward the contact body via the foamed member, wherein
the foamed member includes siloxane bonds, Si-OSi, made of silicon and oxygen, and
a ratio N_{Q}/N_{D} of the number N_{Q} of Q units to the number N_{D} of D units is greater than or equal to 0.09 in silicon contained in the foamed member.

2. The vibration-type actuator according to claim 1, wherein the foamed member is sponge containing silicone rubber.

3. The vibration-type actuator according to claim 1 or 2, wherein an average equivalent circle diameter of air bubbles of the foamed member is greater than 120 µm.

4. The vibration-type actuator according to claim 1 or 2, wherein
the electromechanical energy conversion element includes a piezoelectric material and electrodes, and
a content of lead in the piezoelectric material is less than or equal to 1000ppm.

5. The vibration-type actuator according to claim 1 or 2, wherein the plate portion has a rectangular shape.

6. The vibration-type actuator according to claim 1 or 2, wherein the elastic body has two protruding portions.

7. The vibration-type actuator according to claim 1 or 2, wherein the foamed member is smaller than the electromechanical energy conversion element.

8. The vibration-type actuator according to claim 1 or 2, wherein the foamed member is smaller than the elastic body.

9. The vibration-type actuator according to claim 1 or 2, wherein a main component of the electromechanical energy conversion element is a barium titanate-based material.

10. The vibration-type actuator according to claim 1 or 2, wherein a main component of the electromechanical energy conversion element is barium calcium zirconate titanate.

11. An electronic device comprising:
a member; and
the vibration-type actuator according to claim 1 or 2, provided on the member.

12. An optical apparatus comprising:
at least one of an optical element and an image pickup element; and
the vibration-type actuator according to claim 1 or 2, provided on the at least one of the optical element and the image pickup element.

13. A manufacturing method for a vibration-type actuator, the manufacturing method comprising:
a step of obtaining a foamed member by applying pressurized heat treatment to a foamed material having air bubbles with an average equivalent circle diameter greater than 120 µm and containing silicone rubber;
a step of obtaining a vibrator by bringing an elastic body and an electromechanical energy conversion element into contact with each other;
a step of preparing a contact body; and
a step of obtaining a vibration-type actuator by urging the vibrator toward the contact body via the foamed member.

14. The manufacturing method for a vibration-type actuator according to claim 13, wherein the pressurized heat treatment includes a treatment of holding the foamed material at a temperature higher than or equal to 60°C and lower than or equal to 80°C under a pressure higher than or equal to 600 g/cm² and lower than or equal to 700 g/cm².
